# EUROPEAN PATENT APPLICATION

(11) **EP 3 473 479 A1**
(43) Date of publication of application: **24.04.2019**
(21) Application number: 18190787.4
(22) Date of filing: 24.08.2018
(51) Int. Cl.: B60K 35/00, B60K 37/00, B60Q 3/14, B60R 13/02, B60Q 3/54, B60Q 3/62, H03K 17/96

(54) **LIGHTED TRIM APPARATUS**

(30) Priority: 17.10.2017 US 201715785746
(71) Applicant: Dura Operating, LLC, Auburn Hills, MI 48326 (US)
(72) Inventor: GIPSON, Ron, Metamora, MI 48455 (US)
(74) Representative: Bungartz Christophersen Partnerschaft mbB Patentanwälte

(57) **Abstract**

A lighted trim apparatus includes a light guide sub-assembly. The light guide sub-assembly includes a translucent film layer having a darkening agent on a first surface of the film layer to define multiple translucent windows in the film layer. Multiple light emitting diodes are each mounted on the film layer proximate to one of the windows. A transparent material light guide is applied over the windows and allows light from the light emitting diodes to be transmitted through the windows. A substrate defining an opaque polymeric material layer is commonly applied over the light emitting diodes, the light guide and the first surface of the film and extends beyond a perimeter of the film layer. A transparent cover layer extends over a second surface of the film layer opposite to the first surface and a portion of the opaque polymeric material extends beyond the perimeter of the film layer.

## Description

### FIELD

The present disclosure relates generally to an LED light guide assembly for injection molding plastic encapsulation, in particular to a lighted trim apparatus according to claim 1..

### BACKGROUND

The statements in this section merely provide background information related to the present disclosure and may or may not constitute prior art.

Electronic assemblies with backlit visual elements may be manufactured via several processes. Most commonly, a plastic part of a polymeric material resin is molded with some portion of the plastic being clear or translucent, with electronic components including one or more light sources attached mechanically to the part after molding, so that light is visible through the clear or translucent portion, resulting in a backlighting effect. More recently, methods have been developed of embedding one or more light sources in a molded plastic part. One such method is to encapsulate light sources and associated electronic components (collectively "package") in a clear resin via low-pressure molding and then to injection-mold plastic over or around the encapsulated package. The encapsulated package is thereby embedded in the plastic, with some portion of the plastic being clear or translucent so that light from the encapsulated package is visible through the clear or translucent plastic, resulting in a backlighting effect.

Another such method is to mount light sources and associated electronics ("package") onto a polymer film, form the film into a desired shape, and then insert the formed film into an injection mold having substantially the same shape. A following step injection-molds plastic onto the film such that the package is embedded between the film on which it is mounted and the plastic that has been molded onto it, with portions of the film and/or plastic being clear or translucent such that light from the light sources is visible from the part exterior, resulting in a backlighting effect.

Electronic components may also be printed onto a film. The film is then inserted into an injection mold, where plastic is molded onto the film, the electronic components being embedded in the molded plastic so that when the plastic part is removed from the mold the film is peeled away from the plastic part, leaving the electronic components embedded in or adhered to the surface of the plastic part. Thus, while current printed film assemblies achieve their intended purpose, there is a need for a new and improved system and method for printing film assemblies having light emitting diodes encapsulated in a light guide.

Thus, while current light guide assemblies achieve their intended purpose, there is a need for a new and improved light guide system and method for injection molding light guide assemblies.

### SUMMARY

According to several aspects, a lighted trim apparatus includes a light guide sub-assembly. The light guide sub-assembly includes a translucent film layer having a darkening agent disposed on a first surface of the film layer to define a window in the film layer. An LED is connected to the film layer proximate to the window. A light guide of a substantially transparent material is applied over the window and is configured to allow light from the LED to be transmitted through the window. An opaque polymeric material layer is commonly applied over the LED, the light guide and the first surface of the film and extends beyond a perimeter of the film layer. A transparent cover layer extends over a second surface of the film layer opposite to the first surface and a portion of the opaque polymeric material extending beyond the perimeter of the film layer.

In another aspect of the present disclosure, a second window is provided.

In another aspect of the present disclosure, a third window, a fourth window and a fifth window are provided. An LED is positioned proximate to each of the third window, the fourth window, and the fifth window. Each of the windows are sequentially aligned and do not permit light transmission between any successive ones of the windows.

In another aspect of the present disclosure, a clear or substantially transparent layer of a polymeric material applied onto the film and onto a surface of the opaque polymeric material layer which is substantially co-planar with an outside face of the film layer.

In another aspect of the present disclosure, a substrate is included, wherein a color of the darkening agent is substantially the same color as a color of the substrate to further limit illumination to only the windows.

In another aspect of the present disclosure, a power indicating LED window is created in the film layer illuminated by a dedicated LED. A capacitive sensor detects changes in capacitance to provide simultaneous illumination of multiple indicia such as number pairs individually printed proximate to each of the windows to allow individual selection of any one of the windows for activation.

In another aspect of the present disclosure, when any one of the LEDs is energized the LED light guide allows light transmission in a transmission direction through the LED light guide, through the film layer, and back-illuminates one of a plurality of indicia within each of the windows.

In another aspect of the present disclosure, the film layer is a substantially opaque non-light transmitting polymeric material except at each location of the indicia.

In another aspect of the present disclosure, a polymeric material layer commonly applied over the light guide.

In another aspect of the present disclosure, the polymeric material layer defines an acrylonitrile butadiene styrene (ABS) polymeric material; and the light guide defines a poly-methyl methacrylate (PMMA) material injection molded onto the film layer.

In another aspect of the present disclosure, a lighted trim apparatus includes a light guide sub-assembly. The light guide sub-assembly includes a translucent film layer having a darkening agent disposed on a first surface of the film layer to define multiple substantially translucent windows in the film layer. Multiple light emitting diodes are each mounted on the film ayer proximate to one of the windows. A light guide of a substantially transparent material is applied over the windows and is configured to allow light from the light emitting diodes to be transmitted through the windows. A substrate defining an opaque polymeric material layer is commonly applied over the light emitting diodes, the light guide and the first surface of the film and extending beyond a perimeter of the film layer. A transparent cover layer extends over a second surface of the film layer opposite to the first surface and a portion of the opaque polymeric material extends beyond the perimeter of the film layer.

In another aspect of the present disclosure, the substrate covering the light guide defines a polymeric material film applied using an injection molding process.

In another aspect of the present disclosure, the darkening agent is applied to a back side of the film and extends outwardly beyond the light guide and the light emitting diodes such that only the individual indicia are illuminated and outwardly visible when the light emitting diodes are energized.

In another aspect of the present disclosure, a color of the darkening agent layer is substantially the same color as a color of the substrate, to further limit illumination to only the individual indicia.

In another aspect of the present disclosure, a polymeric material applied to create a non-light transparent or opaque layer over the substrate.

In another aspect of the present disclosure, a clear or substantially transparent layer of a polymeric material applied onto the film layer and onto a surface of the opaque layer which is substantially co-planar with an outside face of the film layer.

In another aspect of the present disclosure, each of the light emitting diodes is connected to a common set of electrical traces extending on the film allowing the light emitting diodes to be individually or all collectively energized.

According to several aspects, a lighted trim apparatus includes a translucent base film having a darkening agent disposed on a first surface of the base film to define multiple substantially translucent windows in the base film. Individual ones of multiple light emitting diodes are positioned proximate to one of the windows. Multiple light guides of a substantially transparent polymeric material are applied to the base film each covering one of the windows and one of the light emitting diodes on a first side of the base film. A set of electrical traces extend lengthwise on the base film having each of the multiple light emitting diodes connected to the set of electrical traces. A substantially transparent polymeric film layer is applied on the first side covering each of the windows, each of the multiple light guides, and each of the multiple light emitting diodes. An opaque light reflective layer of a polymeric material is applied onto a second side of the base film opposite to the first side.

In another aspect of the present disclosure, each of the windows have indicia such as a number pair created as a light transmissive portion of the base film wherein successive windows define a successive pair of integers. Multiple light block elements of a non-light transmissive polymeric material are individually positioned between successive pairs of the windows acting to separate each of the multiple light guides and thereby allow light from a single energized one of the light emitting diodes to only illuminate the indicia created in only one of the windows proximate to the single energized light emitting diode.

In another aspect of the present disclosure, a translucent window is created in the base film. A dedicated light emitting diode is positioned proximate to the translucent window. One of the multiple light block elements is positioned between the translucent window and a closest one of the windows.

Further areas of applicability will become apparent from the description provided herein. It should be understood that the description and specific examples are intended for purposes of illustration only and are not intended to limit the scope of the present disclosure.

### DRAWINGS

The drawings described herein are for illustration purposes only and are not intended to limit the scope of the present disclosure in any way.
FIG. 1 is a top plan view of an LED light guide assembly according to an exemplary aspect;
FIG. 2 is a cross sectional front elevational view of section 2 of FIG. 1;
FIG. 3 is a cross sectional front elevational view modified from FIG. 2 to further show an additional polymeric material layer;
FIG. 4 is a top plan view of a front film portion of an LED light guide assembly according to an further aspect;
FIG. 5 is a top plan view of a light guide sub-assembly modified from the LED light guide assembly of FIG. 4 to further show LED installation;
FIG. 6 is a top plan view of the light guide sub-assembly of FIG. 5 further modified to add a light guide layer;
FIG. 7 is a bottom plan view of the light guide sub-assembly of FIG. 6 modified to add a white reflector film portion;
FIG. 8 is a top plan view of an assembled LED light guide assembly incorporating the elements of FIGS. 4 through 7;
FIG. 9 is a top plan view of a light guide sub-assembly similar to FIG. 6 further modified to add individual light block elements between successive pairs of windows;
FIG. 10 is a top plan view of an assembled LED light guide assembly similar to FIG. 8 modified to connect all LEDs using a common set of electrical traces;
FIG. 11 is a cross sectional front elevational view taken at section 11 of FIG. 10; and
FIG. 12 is a cross sectional front elevational view modified from FIG. 11 to further show an additional polymeric material layer.

### DETAILED DESCRIPTION

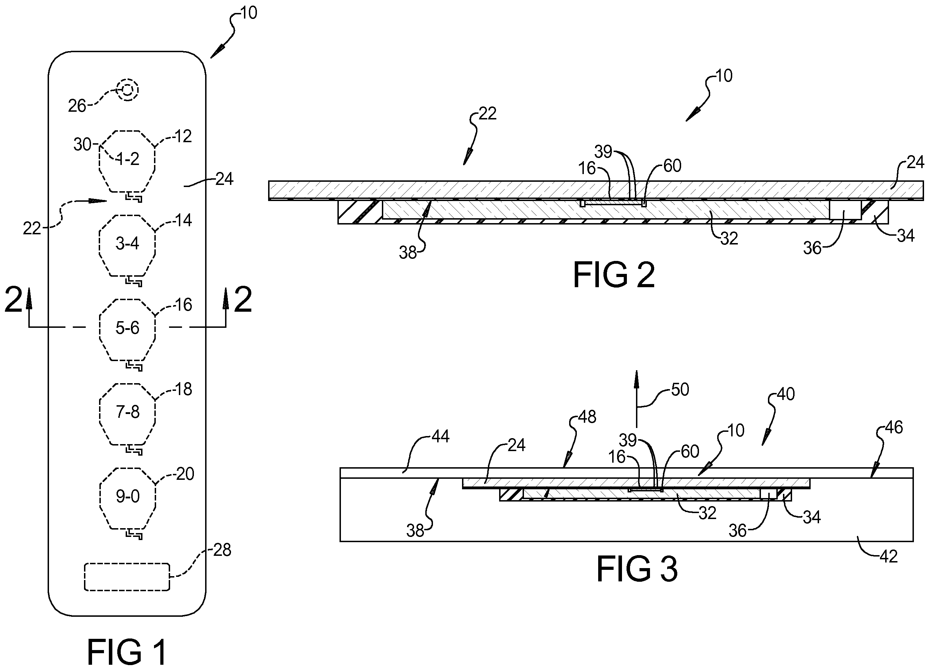

Referring to FIG. 1, a lighted trim apparatus 10 includes multiple printed ink windows, including a first printed ink window 12, a second printed ink window 14, a third printed ink window 16, a fourth printed ink window 18 and a fifth printed ink window 20. The printed ink windows 12, 14, 16, 18, 20 are all successively electrically joined to define a light guide sub-assembly 22. The light guide sub-assembly 22 defines a printed ink layer connected to and covered by a polymeric base film or film layer 24. An individual power indicating LED window 26 may be provided which is illuminated to indicate power is available. A separate capacitive sensor 28 may also be provided to allow simultaneous illumination of all of the indicia or number pairs of all of the printed ink windows 12, 14, 16, 18, 20 to allow individual selection of any one of the printed ink windows for activation.

The printed ink windows 12, 14, 16, 18, 20 are sequentially aligned in a "daisy-chain" configuration such that a number pair 30 of successive printed ink windows define successive pairs of integers, such as for example a number pair 1-2 for the first printed ink window 12, a number pair 3-4 for the second printed ink window 14, continuing successively through a number pair 9-0 for the printed ink window 20. After assembly of the printed ink windows 12, 14, 16, 18, 20 and installation of the film layer 24 the resultant lighted trim apparatus 10 is flexible and can therefore by subsequently shaped to match a curvature and a geometry of a component such as a vehicle door pillar (not shown).

Referring to FIG. 2 and again to FIG. 1, the lighted trim apparatus 10 includes an LED light guide 32 of a transparent or semitransparent polymeric material which is applied for example using an injection molding process to a first side of the light guide sub-assembly 22. The LED light guide 32 is then covered using an injection molding process by a substrate 34, which may be a substantially opaque or non-light transmitting polymeric material. A light emitting diode (LED) 36 is embedded within or positioned proximate to the LED light guide 32 for each of the printed ink windows 12, 14, 16, 18, 20 and is also covered by the substrate 34. The film 24 has a paint or other darkening agent layer 38 applied to a back side of the film 24 and translucent openings 39 are created in the darkening agent layer 38 for visibility of the individual number pairs 30. The darkening agent layer 38 applied to a back side of the film 24 extends outwardly beyond the light guide 32 and the LEDs 36 such that the only illuminated and therefore outwardly visible aspects when the LEDs 36 are energized are the individual number pairs 30. A color of the darkening agent layer 38 is substantially the same color as the color of the substrate 34, which further limits illumination of any items other than the individual number pairs 30.

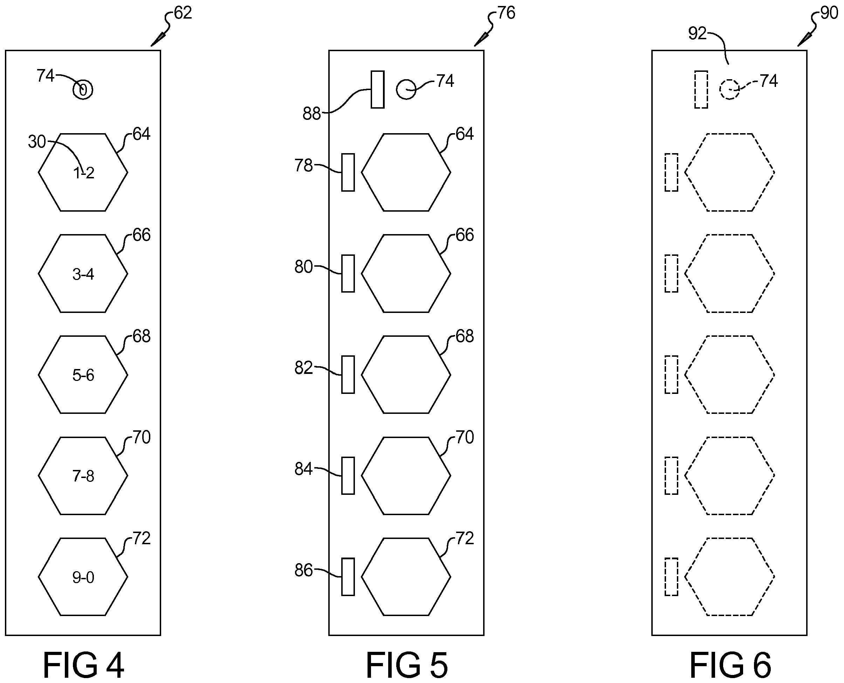

Referring to FIG. 3 and again to FIGS. 1 and 2, after completion of the lighted trim apparatus 10, a completed assembly 40 is created by positioning the lighted trim apparatus 10 into a mold wherein a polymeric material such as acrylonitrile butadiene styrene (ABS) is injected to create a non-light transparent or opaque layer 42 over the substrate 34. A clear or substantially transparent layer 44 of a polymeric material such as poly-methyl methacrylate (PMMA) is then injection molded onto the film 24 and onto a surface 46 of the opaque layer 42 which is substantially co-planar with an outside face of the film 24. The transparent layer 44 allows light transmission in a transmission direction 50 from light generated by the LED 36 which is transmitted via the light guide 32, through the translucent openings 39 created in the darkening agent layer 38 on the film 24 and through the transparent layer 44. The specific LED 36 which is energized back-illuminates the particular number pair 30 of one of the printed ink windows 12, 14, 16, 18 or 20 such as the printed ink window 16 shown. A printed ink window 60 connected to a reflective film is also provided on a back surface of the light guide 32 around the number pair, which is shown and described in greater detail in Reference to FIG. 6.

Referring to FIG. 4 and again to FIGS. 1 through 3, according to further aspects, a film layer 62 similar to the film layer 24 and to the film used to create the film cutouts 56 includes a daisy chain configuration of printed ink windows defining printed ink windows 64, 66, 68, 70, 72 formed on the substantially opaque polymeric film layer 62. Each of the printed ink windows 64, 66, 68, 70, 72 defines a capacitive change sensing window, each including a sequential one of the number pairs 30. The printed ink windows 64, 66, 68, 70, 72 may be overlaid onto the darkened film layer 62, with transparent or translucent portions created in the darkened film layer defining the number pairs 30. A shape of each of the printed ink windows 64, 66, 68, 70, 72 is shown to be polygonal, however any desired shape may be used such as rectangular, circular, and the like. The shape may also be any shape covering an area that does not correspond to the size of the LEDs described in reference to FIG. 5 and the light guide discussed in reference to FIG. 6. An aperture or a transparent or translucent window 74 is provided proximate to one end of the film layer 62, similar to the power indicating LED window 26.

Referring to FIG. 5 and again to FIG. 4, a light guide LED sub-assembly 76 is formed by the addition of an LED 78, 80, 82, 84, 86 proximate to (to the side of) each of the printed ink windows 64, 66, 68, 70, 72 on the film layer 62. A separate or dedicated power indicating LED 88 can be positioned proximate to the transparent or translucent window 74 which may be energized when contact is made with any one or all of the printed ink windows 64, 66, 68, 70, 72.

Referring to FIG. 6 and again to FIGS. 4 through 5, a light guide sub-assembly 90 is then created by the addition of a light guide layer 92 of a transparent or substantially transparent polymeric material such as PMMA onto the printed ink windows 64, 66, 68, 70, 72 of the film layer 62 and onto the LEDs 78, 80, 82, 84, 86, 88. The light guide layer 92 transmits light when any or all of the LEDs 78, 80, 82, 84, 86 are energized to one or all of the number pairs 30 shown in FIG. 4 and transmits light from the LED 88 to the transparent or translucent window 74.

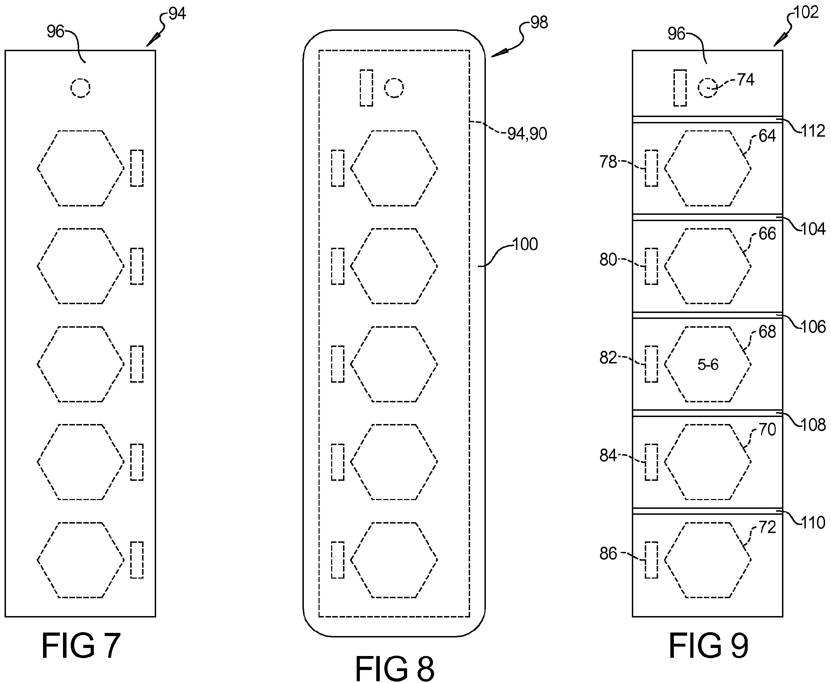

Referring to FIG. 7 and again to FIGS. 4 through 6, after formation of the light guide sub-assembly 90 a reflector film assembly 94 is created by the addition of a substantially opaque light reflective polymeric material layer 96 onto a reverse or back side of the light guide sub-assembly 90.

Referring to FIG. 8 and again to FIGS. 4 through 7, a completed light guide assembly 98 is created by mounting the light guide sub-assembly 90 on a film 100. The light guide sub-assembly 90 can be permanently mounted to the film 100 and subsequently mounted to a component such as a vehicle window pillar, or the light guide sub-assembly 90 can be releasably mounted to the film 100 for subsequent transfer and mounting to a component such as a vehicle window pillar. The film 100 can be an injection molded opaque polymeric material such as acrylonitrile butadiene styrene (ABS) or according to further aspects a substantially transparent polymeric material such as poly-methyl methacrylate (PMMA).

Referring to FIG. 9 and again to FIGS. 4 through 6, the light guide sub-assembly 90 can be modified to create a light guide sub-assembly 102 by the further addition of a non-light transmissive or opaque material as light block elements 104, 106, 108, 110, 112 where shown between each successive pair of the printed ink windows 64, 66, 68, 70, 72 and between the printed ink window 64 and the transparent or translucent window 74. Addition of the light block elements 104, 106, 108, 110, 112 separates and segregates the light guide 92 between printed ink windows and therefore allows light from a single energized LED to only illuminate the number pair of the printed ink window proximate to that specific LED. For example, the number pair 5-6 of the printed ink window 68 would be illuminated by energizing the LED 82, however light from the LED 82 would not illuminate the number pairs of the adjacent printed ink windows 66 or 70.

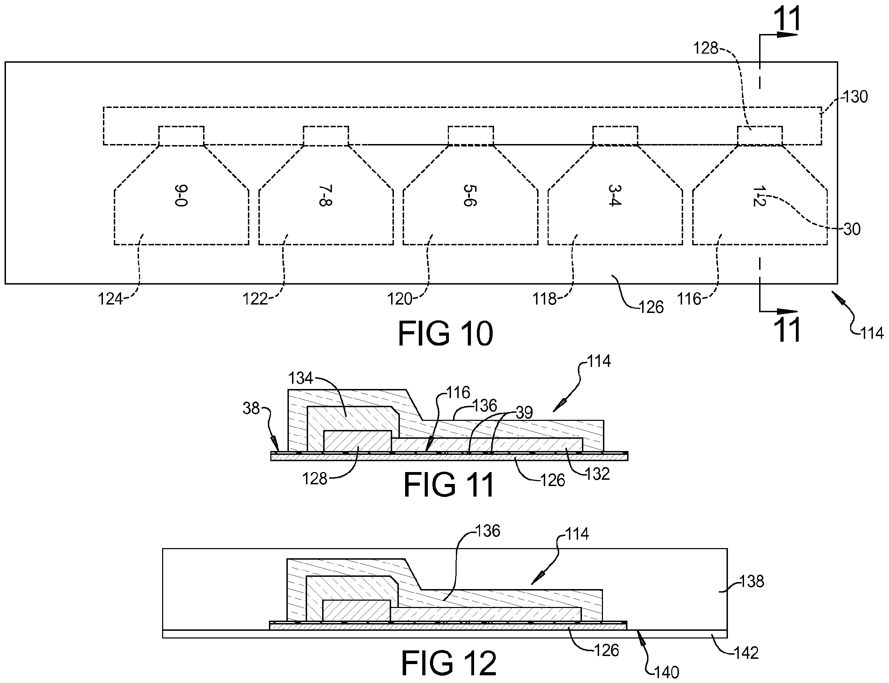

Referring to FIG. 10 and again to FIGS. 1 through 9, a segregated light guide assembly 114 is modified from the light guide sub-assembly 90 and includes a first film portion 116, a second film portion 118, a third film portion 120, a fourth film portion 122, and a fifth film portion 124 each segregated from each other, and each supported on a polymeric base film 126 similar to the film layer 24, having the paint or other darkening agent 38 applied to a back side of the film 24 and the translucent openings 39 created in the darkening agent layer 38 for visibility of the individual number pairs 30. Each of the film portions 116, 118, 120, 122, 124 have the number graphics similar to the number pairs 30 described in reference to FIG. 1. An LED 128 is also provided with each of the film portions 116, 118, 120, 122, 124. Each LED 128 is connected to a common set of electrical traces 130 which extend lengthwise on the base film 126 and can be individually or all collectively energized. A material of the base film 126 can be a transparent polymeric material such as poly-methyl methacrylate.

Referring to FIG. 11 and again to FIG. 10, the segregated light guide assembly 114 provides the film portions 116, 118, 120, 122, 124 (only film portion 116 is shown in this view) printed on the base film 126 proximate to the LEDs 128. A light guide 132 is molded onto the film portions 116, 118, 120, 122, 124, and a light guide portion 134 is also co-molded onto and covers each LED 128. An overmolding 136 is then injection molded over the light guide 132 and the light guide portion 134, and at least partially onto the base film 126 proximate to the film portions 116, 118, 120, 122, 124. According to several aspects, a material of the overmolding 136 can be the same material as the base film 126, and therefore is a translucent or transparent polymeric material such as poly-methyl methacrylate.

Referring to FIG. 12 and again to FIGS. 10 through 11, the segregated light guide assembly 114 can then be inserted into another mold where an injection molded layer 138 such as an acrylonitrile butadiene styrene (ABS) is overmolded onto and over the overmolding 136, leaving a surface 140 of the molded layer 138 co-planar with the base 126 of the segregated light guide assembly 114. A second injection molding is then performed to add a final layer 142 of a transparent polymeric material such as poly-methyl methacrylate onto the surface 140.

Each of the light guide assemblies of the present disclosure commonly includes a darkened film layer having transparent or translucent openings in the darkened film layer, a substantially transparent light guide, an LED mounted on a side together with and proximate to the light guide, a reflective coating, a capacitive change or touch sensor, and a layer of a polymeric material overmolded onto the LED, the light guide, and the darkened film layer.

A lighted trim apparatus of the present disclosure offers several advantages. These include the ability to space the LEDs from the mold walls and thereby to protect the LEDs during injection molding. The layering of clear or substantially transparent polymeric materials over the entire area of the number pairs ensures that the number pairs are backlit, bright and of uniform intensity. The light guide assembly is flexible in its completed form which allows the same assembly to be positioned in a flat, curved, or other geometric component. Individual printed ink windows are powered separately, which provides zone lighting of the printed ink window.

## Claims

1. A lighted trim apparatus (10), comprising:
a translucent base film or film layer (24) having a darkening agent (38) disposed on a first surface of the base film or film layer (24) to define a window in the base film or film layer (24);
a LED (36) positioned proximate to the window;
a light guide (32) of a substantially transparent material applied over the window and configured to allow light from the LED (36) to be transmitted through the window;
an opaque polymeric material layer (34) commonly applied over the LED (36), the light guide (32) and the first surface of the film and extending beyond a perimeter of the base film or film layer (24); and
a transparent cover layer (44) extending over a second surface of the
base film or film layer (24) opposite to the first surface and a portion of the opaque polymeric material (34) extending beyond the perimeter of the film layer (24).

2. The lighted trim apparatus (10) of claim 1, further comprising a
a light guide sub-assembly (22) including
the translucent base film or film layer (24) having the darkening agent (38) disposed on the first surface of the base film or film layer (24) to define the window in the film layer (24);
the LED (36) positioned proximate to the window;
the light guide (32) of a substantially transparent material applied over the window and configured to allow light from the LED (36) to be transmitted through the window;
the opaque polymeric material layer (34) commonly applied over the LED (36), the light guide (32) and the first surface of the film and extending beyond a perimeter of the base film or film layer (24).

3. The lighted trim apparatus (10) of claim 1 or claim 2, further including a second window, and preferably further including:
a third window, a fourth window and a fifth window;
an LED positioned proximate to each of the third window, the fourth window, and the fifth window;
wherein each of the windows are sequentially aligned and do
not permit light transmission between any successive ones of the windows.

4. The lighted trim apparatus (10) of any one of the preceding claims, further including a substrate (34), wherein a color of the darkening agent (38) is substantially the same color as a color of the substrate (34), to further limit illumination to only the windows.

5. The lighted trim apparatus (10) of claim 3 or claim 4, further including:
a power indicating LED window (26) created in the film layer (24)
illuminated by a dedicated LED;
multiple indicia individually provided within each of the windows; and
a capacitive sensor (28) detecting changes in capacitance to provide
simultaneous illumination of the multiple indicia individually provided within each of the windows to allow individual selection of any one of the windows for activation.

6. The lighted trim apparatus (10) of any one of claims 3 to 5, wherein when any one of the LEDs is energized the LED light guide (32) allows light transmission in a transmission direction through the LED light guide (32), through the film layer (24), and back-illuminates one of a plurality of indicia within each of the windows and wherein the film layer (24) is preferably a substantially opaque non-light transmitting polymeric material except at each location of the indicia.

7. The lighted trim apparatus (10) of any one of the preceding claims, further including a polymeric material layer commonly applied over the light guide (32).

8. The lighted trim apparatus (10) of any one of the preceding claims, wherein:
the polymeric material layer (42) defines an acrylonitrile butadiene
styrene (ABS) polymeric material; and
the light guide (32) defines a poly-methyl methacrylate (PMMA) material injection molded onto the film layer (24).

9. The lighted trim apparatus (10) of claim 1, comprising
a light guide sub-assembly (22) including
the translucent film layer (24) having the darkening agent (38), wherein the darkening agent (38)
is disposed on the first surface of the film layer (24) to define multiple substantially translucent windows in the film layer (24);
multiple light emitting diodes, each mounted on the film layer (24) proximate to one of the windows;
the light guide (32) of a substantially transparent material,
wherein the light guide (32)
is applied over the windows and configured to allow light from the light emitting diodes to be transmitted through the windows;
a substrate (34) defining the opaque polymeric material layer commonly applied over the light emitting diodes, the light guide (32) and the first surface of the film and extending beyond a perimeter of the film layer (24); and wherein (24); wherein the substrate (34) covering the light guide preferably defines a polymeric material film applied using an injection molding process.

10. The lighted trim apparatus of claim 9, wherein the translucent windows define individual indicia, wherein the darkening agent (38) is applied to a back side of the film and extends outwardly beyond the light guide (32) and the light emitting diodes such that only the individual indicia are illuminated and outwardly visible when the light emitting diodes are energized; and wherein a color of the darkening agent layer (38) is preferably substantially the same color as a color of the substrate (34), to further limit illumination to only the individual indicia.

11. The lighted trim apparatus (10) of claims 9 or 10, further including a polymeric material applied to create a non-light transparent or opaque layer over the substrate (34).

12. The lighted trim apparatus (10) of one of the preceding claims, wherein the transparent cover layer (44) is of a polymeric material and is applied onto the film layer (24) and onto a surface of the opaque layer which is substantially co-planar with an outside face of the film layer (24).

13. The lighted trim apparatus (10) of any one of claims 9 to 12, wherein each of the light emitting diodes is connected to a common set of electrical traces (130) extending on the film allowing the light emitting diodes to be individually or all collectively energized.

14. The lighted trim apparatus (10) of claim 1, wherein:
the translucent base film having a darkening agent (38) is disposed on a
first surface of the base film (24) to define multiple substantially translucent windows in the base film (24); further comprising
multiple light emitting diodes having individual ones of the light emitting diodes positioned proximate to one of the windows;
multiple light guides of a substantially transparent polymeric material applied to the base film (24) each covering one of the windows and one of the light emitting diodes on a first side of the base film (24);
a set of electrical traces (130) extending lengthwise on the base film (24)
having each of the multiple light emitting diodes connected to the set of electrical traces (130);
a substantially transparent polymeric film layer applied on the first side covering each of the windows, each of the multiple light guides, and each of the multiple light emitting diodes; and
an opaque light reflective layer of a polymeric material applied onto a second side of the base film opposite to the first side.

15. The lighted trim apparatus of claim 14, further including:
each of the windows having an indicia created as a light transmissive portion of the base film wherein successive windows define a successive pair of integers;
multiple light block elements of a non-light transmissive polymeric material individually positioned between successive pairs of the windows acting to separate each of the multiple light guides and thereby allow light from a single energized one of the light emitting diodes to only illuminate the indicia created in only one of the windows proximate to the single energized light emitting diode; and preferably further including:
a translucent window created in the base film;
a dedicated light emitting diode positioned proximate to the translucent window; and
one of the multiple light block elements positioned between the translucent window and a closest one of the windows.
